# EUROPEAN PATENT APPLICATION

(11) **EP 0 826 756 A1**
(43) Date of publication of application: **04.03.1998**
(21) Application number: 97306684.8
(22) Date of filing: 29.08.1997
(51) Int. Cl.: C09K 3/14, C09G 1/02, C04B 35/50, H01L 21/321

(54) **Abrasive composition for polishing a metal layer on a semiconductor substrate, and use of the same**

(30) Priority: 03.09.1996 JP 233140/96
(71) Applicant: SUMITOMO CHEMICAL COMPANY, LIMITED, Chuo-ku Osaka 541 (JP)
(72) Inventor: Sakatani, Yoshiaki, Niihama-shi, Ehime (JP); Ueda, KAzumasa, Niihama-shi, Ehime (JP); Takeuchi, Yoshiaki, Niihama-shi, Ehime (JP)
(74) Representative: Bentham, Stephen

(57) **Abstract**

An abrasive composition for polishing a metal layer on a semiconductor substrate is provided comprising an oxidizing agent, abrasive particles which comprise cerium oxide, and optionally abrasive particles which comprise at least one oxide selected from (a) metal oxides other than cerium oxide and (b) silicon oxide, the abrasive particles having a mean particle size of 3 µm or less. A method for polishing and planarizing a metal layer formed on a semiconductor substrate, a method of increasing evenness of the surface of a metal layer on a semiconductor substrate and a process for polishing the surface of a metal layer on a semiconductor substrate to prevent the occurrence of wire breaking using the abrasive composition are also provided.

## Description

The present invention relates to an abrasive composition for polishing a metal layer on a semiconductor substrate and a method of polishing and planarizing the metal layer using the abrasive composition.

With extensive development of LSI techniques, integrated circuits have further been micronized and multilayer interconnected circuits have been frequently made. The multilayer interconnection of an integrated circuit enlarges unevenness on the surface of a semiconductor and the presence of the unevenness causes breaks in the printing and local increase in the resistance. And further in conjunction with the micronization of integrated circuits, the presence of the unevenness brings about a wire breaking, current capacity decrease and an occurrence of electromigration.

Therefore, a planarizing technique which planarizes a metal wiring and an interlayer insulating layer of a multilayer interconnected substrate and which decreases an unevenness between layers is required. Various planarizing processing techniques have been developed, and one of them is a chemical mechanical polishing technique (CMP method). This technique is used for the planarizing of an interlayer insulating layer, the formation of embedded wirings in the board and plug formation in production of semiconductors.

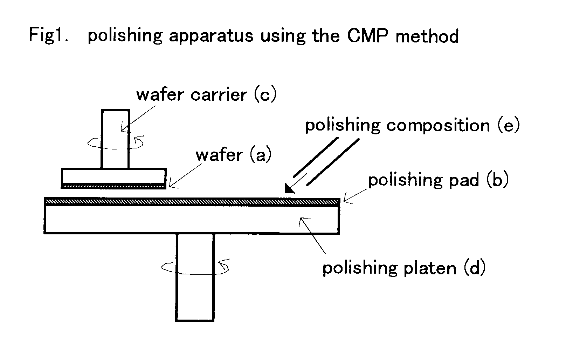

Fig. 1 shows a schematic view of a polishing apparatus using the CMP method. The polishing is conducted as follows. That is, usually, a flat wafer (a) comprising a semiconductor material is kept on a wafer carrier (c) while introducing constant suction to the wafer carrier (c) in order to keep the wafer (a) attached to the wafer carrier (c). And a polishing platen (d) which supports a polishing pad (b) and the wafer carrier (c) which supports the wafer (a) are respectively rotated in the same directions as shown by the arrows for conducting the polishing. In this process, protruding parts of the insulating layer and the wiring are polished and planarized by a polishing composition introduced between the wafer and polishing pad. The properties of materials and additives in the polishing composition and the particle size of the abrasive particles in the polishing composition exert serious influence on the polishing rate and surface condition of the polished surface.

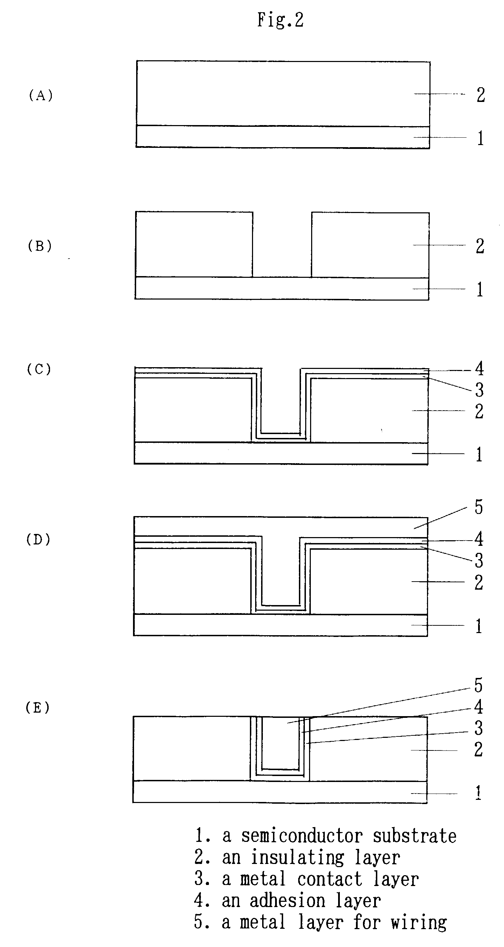

Fig. 2 shows one example for forming an embedded metal wiring board using the CMP method. Fig 2 (A) to (E) are all sectional views and show only metal wiring parts.

First, as shown in Fig (A), an insulating layer 2 is formed on a semiconductor substrate 1 such as a silicon substrate, and the resulting insulating layer 2 is polished and planarized using an abrasive composition. A composition obtained by mixing a colloidal silica with an alkaline component such as potassium hydroxide or a composition containing cerium oxide is usually used as the abrasive composition for an insulating layer .

As shown in Fig 2 (B), slits for metal wiring or openings for connecting wiring are formed in the insulating layer 2 by a photolithography method and etching method.

Next, as shown in Fig. 2 (C), a 'metal contact layer' 3 such as a titanium layer and an adhesion layer 4 such as a titanium nitride layer are formed on the slits or openings in the insulating layer 2 by methods such as sputtering or a chemical vapor deposition (CVD method), so that no mutual diffusion or reaction occur between the insulating layer 2 and 'metal layer for wiring' 5.

Next, as shown in Fig. 2 (D), the 'metal layer for wiring' 5 is embedded in the slits or openings formed in the insulating layer 2 by methods such as sputtering or CVD method, so that the thickness thereof is greater than the depth of the slits or openings formed in the insulating layer 2. As for the metal layer 5, a tungsten layer, an aluminum layer or a copper layer is generally used.

Next, as shown in Fig. 2 (E), surplus components of the metal layers 3, 5 and the adhesion layer 4 other than the components among the slits and openings are removed by polishing.

For polishing the metal layers 3, 5 and the adhesion layer 4, an abrasive composition, which comprises an abrasive particle such as aluminum oxide or silicon oxide and an oxidizing agent such as hydrogen peroxide is usually used.

When the abrasive particle for polishing the metal layers 3, 5 and the adhesion layer 4 is aluminum oxide, for example, aluminum oxide of which crystalline form is α-type has high hardness and manifests high polishing rate, but such aluminum oxide produces the disadvantages that defects such as micro scratches and orange peel effects are formed on the surface of the metal layer 5 and insulating layer 2. Alternatively, when the abrasive particle is a transition alumina such as γ-type aluminum oxide, amorphous aluminum oxide or silicon oxide, which has lower hardness than the α-type, the abrasive particle can suppress the forming of defects such as micro scratches and orange peel effects on the surface of the metal layer 5 and the insulating layer 2, but it causes the disadvantage that sufficient polishing rate can not be obtained in polishing the metal layers 3, 5 and the adhesion layer 4.

An abrasive composition containing cerium oxide as a main component without an oxidizing agent is widely used as a polishing composition for polishing an insulating layer 2. For example, Japanese Patent Application Laid-Open (JP-W) No.7(1995)-502778 discloses an abrasive composition having pH of 4 to 12 and comprising abrasive particles containing about 30 to 50% by weight of cerium oxide, about 8 to 20% by weight of fumed silica and about 15 to 45% by weight of precipitated silica. And it is described that the abrasive composition can be used for polishing metal layer 5 such as tungsten as well as used for polishing the insulating layer 2.

However, when these known abrasive compositions containing as a main component cerium oxide without an oxidizing agent are used as a polishing composition for polishing the metal layer 3 embedded in the insulating layer 2 on a semiconductor substrate, the polishing rate against the insulating layer 2 is quite large as well as against the metal layer, the polishing selectivity against the metal layer and insulating layer is poor, and the insulating layer is unnecessarily polished on the completion of polishing.

Further, Japanese Patent Application Laid-Open (JP-A) No. 8(1996)-153696 describes that cerium oxide having low content of impurities such as sodium is applied in an abrasive composition for organic and inorganic insulating layers in the alkaline pH range of 7.5 or more, or in the acidic pH range of 6.5 or less. However, there is no description to use the composition for polishing a metal layer on a semiconductor substrate.

As described above, when polishing is conducted using the conventional polishing composition for planarizing a metal layer on a semiconductor substrate in a process for producing a semiconductor, there are problems for example defects occur on the polished surface, polishing rate is slow, or polishing selectivity against a metal layer and an insulating layer is low. On the contrary, the present invention provides an abrasive composition for polishing a metal layer on the semiconductor substrate which can be used as a polishing composition which provides for high polishing rate without causing defects on a metal layer formed on a semiconductor substrate, which is excellent in polishing selectivity against a metal layer and an insulating layer, which does not cause defects on the surface of the insulating layer, and which can planarize the surface of the metal layer and the insulating layer by polishing. The present invention also provides a method for polishing and planarizing of a metal layer formed on a semiconductor substrate, a method of providing for high polishing rate without causing defects on a metal layer on a semiconductor substrate, a method of increasing of evenness of a surfac'e of a metal layer on a semiconductor substrate and a process for polishing a surface of a metal layer on a semiconductor substrate to prevent the occurrence of wire breaking, using said abrasive composition.

The present invention provides an abrasive composition for a metal layer on a semiconductor substrate comprising an oxidizing agent and abrasive particles which have a mean particle size of 3 µm or less and which comprise cerium oxide or a metal oxide containing cerium oxide as a main component.

The present invention also provides a method for polishing and planarizing a metal layer formed on a semiconductor substrate using the abrasive composition comprising an oxidizing agent and abrasive particles which have a mean particle size of 3 µm or less and which comprise cerium oxide or a metal oxide containing cerium oxide as a main component.

The abrasive composition of the present invention comprises abrasive particles and an oxidizing agent.

The abrasive particles of the present invention are cerium oxide or a metal oxide containing cerium oxide as a main component and have a mean particle size of secondary particles measured by a light scattering method (micro track method) of 3 µm or less, preferably 0.2 µm to 1.5 µm.
When the mean particle size of the abrasive particles is more than 3 µm and such particles are used in an abrasive composition, defects such as scratches and orange peel effects are formed on the polished surface.

In the present invention, the metal oxide containing cerium oxide as a main component is preferably a material containing cerium oxide in an amount of about 50% or more by weight. When the content of cerium oxide is less than about 50% by weight in the metal oxide, the polishing rate is slow, though a metal oxide of which cerium oxide content is for example 40% or more by weight or 30% or more by weight can be used.

The metal oxide containing cerium oxide of the present invention comprises a metal oxide other than cerium oxide as a sub-component. The sub-component is preferably at least one oxide selected from aluminum oxide, silicon oxide, titanium oxide and zirconium oxide. The sub-component is preferably aluminum oxide, and is more preferably aluminum oxide of which crystalline form is γ , δ , θ , *κ* or σ-type transition alumina or amorphous aluminum oxide. When a metal oxide containing transition alumina is used, the polished surface after polishing becomes extremely planarised and excellent surface. However, when a-type aluminum oxide is mixed, a disadvantage that defects are formed on the polished surface may sometimes be caused.

A method of producing the sub-component is not particularly restricted, and known methods can be used. For example, an alkoxide method in which a metal alkoxide is hydrolyzed in alcohol or a vapour phase method in which a metal compound is vaporized and hydrolyzed with burning in oxygen hydrogen flame can be used.

In the present invention, the abrasive particles comprising the metal oxide containing cerium oxide as a main component can be produced, for example, by homogeneous mixing a main component cerium oxide with a sub-component oxide in dry or wet condition.

In the present invention, a method of producing cerium oxide is not particularly restricted, and known methods such as a dry oxidation method using a cerium chloride as a raw material, an air oxidation method, a chlorine method, a phosphate method using a cerium phosphate as a raw material, a method using bastnaesite ore as a raw material and the like can be used.

In these methods, cerium oxide which is commercially available can also be used. Examples thereof include REMILLOX (trade name) manufactured by Fujimi Inc., and OPALINE (trade name) manufactured by Rhone-Poulenc SA.

The abrasive composition of the present invention is usually used in the form of a slurry and pH thereof is preferably about 7 or less, and more preferably about 5 or less, most preferably about 4 or less. When pH is over about 7, the surface appearance of a metal layer after polishing is not so good.

Though this pH depends on the kind and amount of oxidizing agent added, it can be suitably prepared by adding acid and/or alkali components in the pH range in which the above-mentioned oxidizing agent is stable.

The abrasive composition of the present invention contains an oxidizing agent, therefore, can polish the surface of a polishing-resistant metal layer with oxidizing the surface by the aid of the agent and can increase the polishing rate. Examples of the oxidizing agent used include known oxidizing agents such as hydrogen peroxide, iron (III) nitrate, iodic acid and iodate. Examples of the preferred oxidizing agent include hydrogen peroxide and iron (III) nitrate.

The oxidizing agent is preferably used in an amount of 0.5% by weight to 15% by weight or of 0.5% by volume to 15% by volume based on the abrasive composition. The time when the oxidizing agent is added to the abrasive composition is not particularly limited if the oxidizing agent does not change its property, and preferably, the oxidizing agent is added immediately before polishing.

The abrasive composition of the present invention can be used for polishing and planarizing a metal layer on a semiconductor substrate, and can be used in the form of a slurry dispersed in water.

For forming the slurry, an abrasive particle, oxidizing agent and water may be mixed simultaneously and be dispersed, and any component may be mixed successively in any order to previously prepare the slurry. That is, an abrasive particle and water, an abrasive particle and oxidizing agent, an oxidizing agent and water may respectively be mixed, and when used for polishing, remaining one component, namely the oxidizing agent, water and an abrasive particle respectively may be mixed and be dispersed to obtain a slurry to be used.

To disperse these components to obtain the slurry, for example, dispersing methods using a homogenizer, ultrasonic disperser or wet atmosphere agitation mill may be used.

The content of abrasive particles based on the slurry, namely the slurry concentration is usually 1 to 30% by weight.

The abrasive particles of the present invention can contain water as mentioned before.

Additives such as a dispersing agent, precipitation inhibitor or defoaming agent may optionally be added to the abrasive composition of the present invention and the resulting mixture may be used for a polishing composition.

The abrasive composition of the present invention thus prepared in the form of a slurry can be used for polishing and planarizing of a metal layer on a semiconductor substrate. In this case, the abrasive composition in the form of a slurry has pH usually of about 7 or less, preferably about 5 or less.

The metal layer on a semiconductor substrate which is an object to be polished is not particularly restricted, and examples thereof include tungsten W, aluminum Al, copper Cu, titanium Ti and alloy thereof, and known metal layers for wiring, plug and metal contact layer.

As described above in detail, according to the present invention, there is provided an abrasive composition for polishing a metal layer on the semiconductor substrate which polishes a metal layer at high rate, which is excellent in polishing selectivity against a metal layer and an insulating layer. And this polishing is carried out by a simple method that an abrasive composition is obtained by mixing an oxidizing agent and abrasive particles in the form of a slurry and used under pH condition of about 7 or less, preferably of about 5. So the composition has extremely high industrial availability as an abrasive composition for polishing of a metal layer on a semiconductor substrate.

The following Examples and Comparative Examples further illustrate the present invention in detail but are not to be construed to limit the scope thereof.

In Examples and Comparative Examples, the measurements were conducted according to the following methods.

### Mean particle size:

A particle size at 50% cumulation was measured by a Micro track MK II particle size analyzer (SPA model 7997-20 manufactured by Nikkiso Co., Ltd.), and was recognized as mean particle size. The term " mean particle size" of the present invention means mean particle size of the secondary particles measured by this method.

### Example 1

9 g of cerium oxide having a mean particle size of 0.3 µm was dispersed in 141 g of water to obtain 150 g of a 6% by weight polishing slurry, and 150 g of a 10% by weight aqueous solution of iron (III) nitrate 9 hydrate as an oxidizing agent was mixed with this slurry to prepare an abrasive composition. The mixing ratio by weight of the polishing slurry to the aqueous solution of iron (III) nitrate 9 hydrate was 1:1, the slurry concentration of cerium oxide was 3% by weight, and pH of the slurry was 1.1.

Using the resulting abrasive composition, a tungsten layer, titanium layer and silicon oxide layer were respectively polished. The tungsten layer and titanium layer (a thickness of these layers : about 0.8 µm respectively were polished under conditions of a processing pressure of 300 g/cm² and a platen speed of 200 rpm, and SUBA 800 (trade name, manufactured by Rodel company) was used as a polishing pad. On the other hand, the silicon oxide layer (a thickness of the layer : about one µm) was polished under conditions of a processing pressure of 300 g/cm² and a platen speed of 140 rpm, and SUBA 800 (trade name, manufactured by Rodel company) was used as polishing pad. At any case, the polishing rate was measured, and surface condition after polishing, and an occurrence of defects were investigated. The mean particle size of the abrasive particle and composition abstract of the abrasive composition are shown in Table 1, and the results of the measurements are shown in Table 2.

### Example 2

9 g of a cerium oxide powder (trade name: REMILLOX , manufactured by Fujimi Inc.) having a mean particle size of 2.5 µm was dispersed in 141g of water in the same manner as in Example 1 to obtain 150 g of a polishing slurry, and 150 g of a 10% by weight aqueous solution of iron (III) nitrate 9 hydrate as an oxidizing agent was mixed with this slurry to prepare an abrasive composition. The mixing ratio by weight of the polishing slurry to the aqueous solution of iron (III) nitrate 9 hydrate was 1 : 1, the slurry concentration of cerium oxide was 3% by weight, and pH of the slurry was 1.1.

Using the resulting abrasive composition, a tungsten layer, titanium layer and silicon oxide layer were respectively polished in the same conditions as those of Example 1. The mean particle size of the abrasive particle and composition abstract of the abrasive composition are shown in Table 1, and the results of the measurements are shown in Table 2.

### Example 3

To 150 g of the same polishing slurry which had not contained the oxidizing agent yet as in Example 2 were added 97.05 g of 30% aqueous solution of hydrogen peroxide as an oxidizing agent and 52.95 g of water, then they were mixed, pH thereof was prepared to be 3.8 by adding of nitric acid to obtain an abrasive composition. The amount of added hydrogen peroxide herein was about 10% by volume based on the abrasive composition, and the slurry concentration of cerium oxide was 3% by weight.

Using the resulting abrasive composition, a tungsten layer, titanium layer and silicon oxide layer were respectively polished in the same manner as in Example 1. The mean particle size of the abrasive particle and composition abstract of the abrasive composition are shown in Table 1, and the results of the measurements are shown in Table 2.

### Example 4

To 150 g of the same polishing slurry which had not contained the oxidizing agent yet as in Example 2 were added 97.05 g of 30% aqueous solution of hydrogen peroxide as an oxidizing agent and 52.95 g of water, then they were mixed, pH thereof was prepared to be 7 by adding of aqueous ammonia to obtain an abrasive composition. The amount of added hydrogen peroxide herein was about 10% by volume based on the abrasive composition, and the slurry concentration of cerium oxide was 3% by weight.

Using the resulting abrasive composition, a tungsten layer, titanium layer and silicon oxide layer were respectively polished in the same manner as in Example 1. The mean particle size of the abrasive particle and composition abstract of the abrasive composition are shown in Table 1, and the results of the measurements are shown in Table 2.

### Comparative Example 1

9 g of cerium oxide having a mean particle size of 0.3 µm was dispersed in 291 g of water to obtain 300 g of a 3% by weight polishing slurry, and pH thereof was prepared to be 1.2 by adding of nitric acid to obtain an abrasive composition.

Using the resulting abrasive composition, a tungsten layer, titanium layer and silicon oxide layer were respectively polished in the same manner as in Example 1. The mean particle size of the abrasive particle and composition abstract of the abrasive composition are shown in Table 1, and the results of the measurements are shown in Table 2.

### Comparative Example 2

9 g of a cerium oxide powder (trade name: REMILLOX , manufactured by Fujimi Inc.) having a mean particle size of 2.5 µm was dispersed in 291g of water in the same manner as in Example 1 to obtain 300 g of a polishing slurry, and pH thereof was prepared to be 3.8 by adding of nitric acid to obtain an abrasive composition.

Using the resulting abrasive composition, a tungsten layer, titanium layer and silicon oxide layer were respectively polished in the same manner as in Example 1. The mean particle size of the abrasive particle and composition abstract of the abrasive composition are shown in Table 1, and the results of the measurements are shown in Table 2.

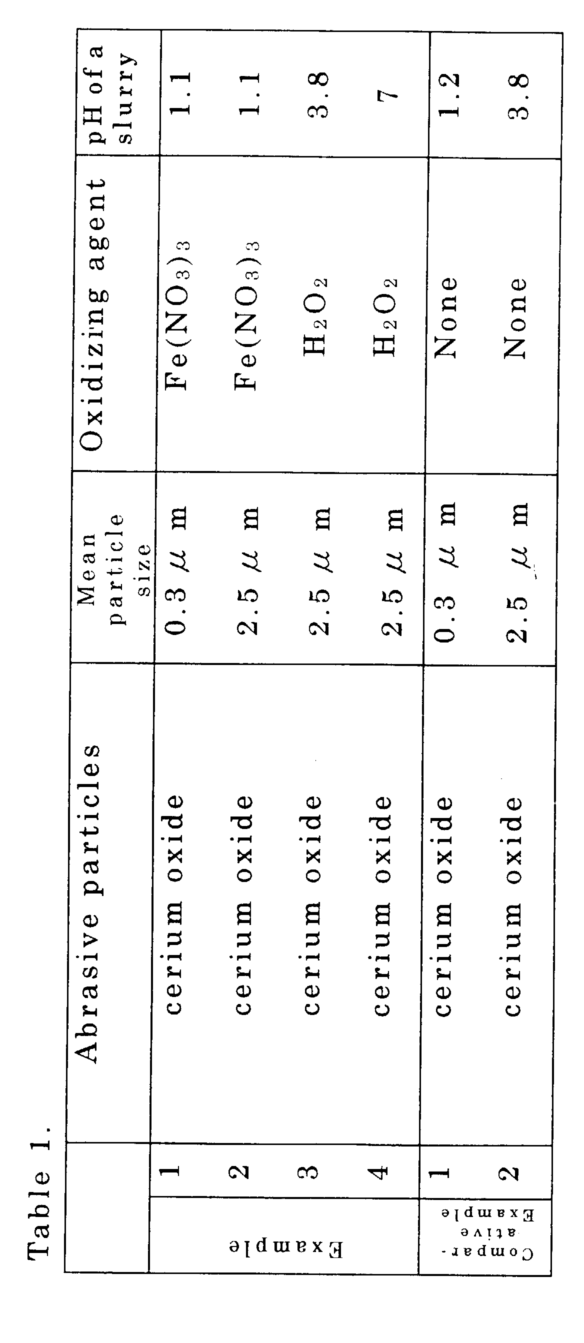

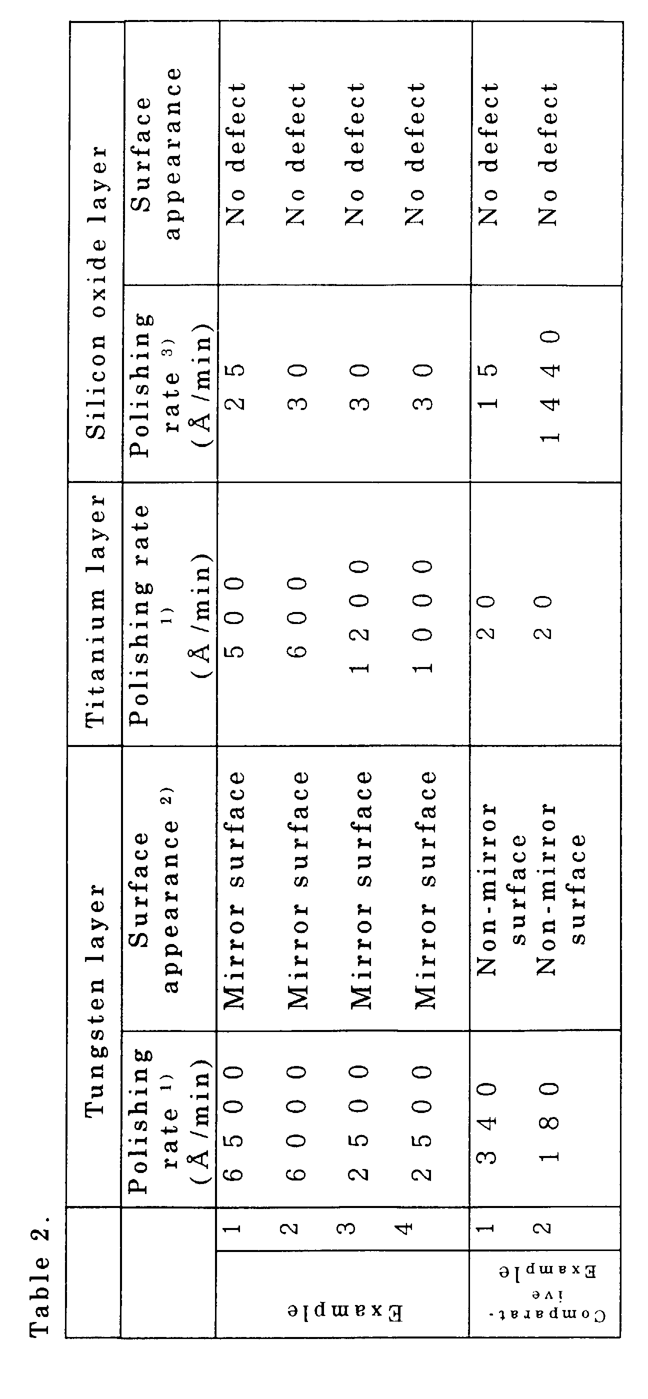

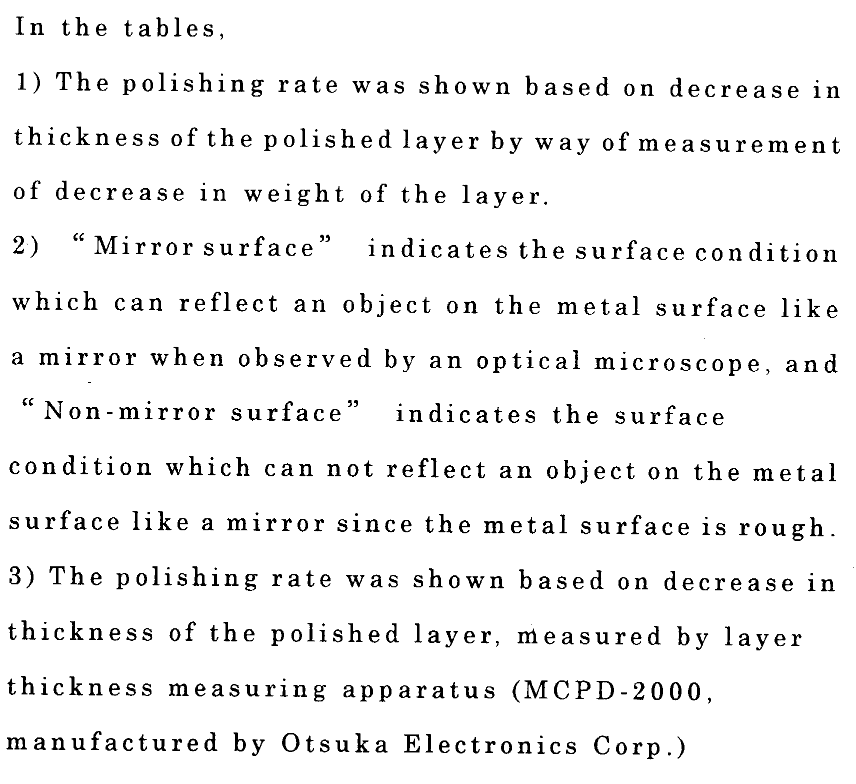

Table 2 shows that the abrasive composition of the present invention polishes a metal layer such as a tungsten layer or a titanium layer formed on a semiconductor substrate at high polishing rate without causing defects such as micro scratch and orange peel on the surface of the metal layer although the composition polishes an insulating layer only at low polishing rate. The composition also polishes an insulating layer without causing defects on the surface of the insulating layer. This indicates the composition has excellent polishing selectivity against the metal layer and the insulating layer without causing defects on the surfaces of both the metal layer and the insulating layer, and does not unnecessarily polish the insulating layer.

### Example 5

The same procedure as in Example 1 was conducted except that 9 g of a mixed powder consisting of (i) 3.6 g of a γ-alumina powder having a mean particle size of 0.40 µm and (ii) 5.4 g, i.e. 60% by weight, cerium oxide powder having a mean particle size of 0.3 µm was used instead of the cerium oxide in Example 1, to obtain 150 g of a polishing slurry. Into this polishing slurry was mixed 150 g of a 10% by weight aqueous solution of iron (III) nitrate 9 hydrate to prepare an abrasive composition. The mixing ratio by weight of the polishing slurry to the aqueous solution of iron (III) nitrate 9 hydrate herein was 1:1, the slurry concentration of the mixed powder was 3% by weight, and the pH of the slurry was 1.1.

Using the resulting abrasive composition, a tungsten layer, titanium layer and silicon oxide layer were respectively polished in the same manner as in Example 1. The mean particle size of the abrasive particle and composition abstract of the abrasive composition are shown in Table 3 , and the results of the measurements are shown in Table 4.

### Example 6

The same procedure as in Example 1 was conducted except that 9 g of a mixed powder consisting of (i) 4.5 g of a γ-alumina powder having a mean particle size of 0.40 µm and (ii) 4.5 g, i.e. 50% by weight, cerium oxide powder having a mean particle size of 0.3 µm was used instead of the cerium oxide in Example 1, to obtain 150 g of a polishing slurry. Into this polishing slurry was mixed 150 g of a 10% by weight aqueous solution of iron (III) nitrate 9 hydrate to prepare an abrasive composition. The mixing ratio by weight of the polishing slurry to the aqueous solution of iron (III) nitrate 9 hydrate herein was 1:1, the slurry concentration of the mixed powder was 3% by weight, and the pH of the slurry was 1.1.

Using the resulting abrasive composition, a tungsten layer, titanium layer and silicon oxide layer were respectively polished in the same manner as in Example 1. The mean particle size of the abrasive particle and composition abstract of the abrasive composition are shown in Table 3 , and the results of the measurements are shown in Table 4 .

### Comparative Example 3

The same procedure as in Example 1 was conducted except that a mixed powder consisting of (i) 7.2 g of a γ-alumina powder having a mean particle size of 0.40 µm and (ii) 1.8 g, i.e. 20% by weight, cerium oxide powder having a mean particle size of 0.3 µm was used instead of the cerium oxide powder in Example 1, to obtain 150 g of a polishing slurry. Into this polishing slurry was mixed 150 g of a 10% by weight aqueous solution of iron (III) nitrate 9 hydrate to obtain an abrasive composition. The mixing ratio by weight of the polishing slurry to the aqueous solution of iron (III) nitrate 9 hydrate herein was 1:1, the slurry concentration of the mixed powder was 3% by weight, and the pH of the slurry was 1.1.

Using the resulting abrasive composition, a tungsten layer, titanium layer and silicon oxide layer were respectively polished in the same manner as in Example 1. The mean particle size of the abrasive particle and composition abstract of the abrasive composition are shown in Table 3 , and the results of the measurements are shown in Table 4 .

### Comparative Example 4

The same procedure as in Example 1 was conducted except that 9 g of a γ-alumina powder having a mean particle size of 0.40 µm was used instead of the cerium oxide powder in Example 1, to obtain 150 g of a polishing slurry. Into this polishing slurry was mixed 150 g of a 10% by weight aqueous solution of iron (III) nitrate 9 hydrate as an oxidizing agent to obtain an abrasive composition. The mixing ratio by weight of the polishing slurry to the aqueous solution of iron (III) nitrate 9 hydrate herein was 1 : 1, the slurry concentration of the γ-alumina powder was 3% by weight, and the pH of the slurry was 1.1.

Using the resulting abrasive composition, a tungsten layer, titanium layer and silicon oxide layer were respectively polished in the same manner as in Example 1. The mean particle size of the abrasive particle and composition abstract of the abrasive composition are shown in Table 3, and the results of the measurements are shown in Table 4

### Comparative Example 5

The same procedure as in Example 1 was conducted except that 9 g of an α-alumina powder having a mean particle size of 0.39 µm was used instead of the cerium oxide powder in Example 1, to obtain 150 g of a polishing slurry. Into this polishing slurry was mixed 150 g of a 10% by weight aqueous solution of iron (III) nitrate 9 hydrate as an oxidizing agent to obtain an abrasive composition. The mixing ratio by weight of the polishing slurry to the aqueous solution of iron (III) nitrate 9 hydrate herein was 1 : 1, the slurry concentration of the α-alumina powder was 3% by weight, and the pH of the slurry was 1.1.

Using the resulting abrasive composition, a tungsten layer, titanium layer and silicon oxide layer were respectively polished in the same manner as in Example 1. The mean particle size of the abrasive particle and composition abstract of the abrasive composition are shown in Table 3, and the results of the measurements are shown in Table 4.

### Comparative Example 6

To 150 g of the same polishing slurry which had not contained the oxidizing agent yet as in Example 2 were added 97.05 g of 30% aqueous solution of hydrogen peroxide as an oxidizing agent and 52.95 g of water, then they were mixed, pH thereof was prepared to be 9 by adding of aqueous ammonia to obtain an abrasive composition. The amount of added hydrogen peroxide herein was about 10% by volume based on the abrasive composition, and the slurry concentration of cerium oxide was 3% by weight.

Using the resulting abrasive composition, a tungsten layer, titanium layer and silicon oxide layer were respectively polished in the same manner as in Example 1. The mean particle size of the abrasive particle and composition abstract of the abrasive composition are shown in Table 3, and the results of the measurements are shown in Table 4.

### Comparative Example 7

The same procedure as in Example 1 was conducted except that 9 g of the cerium oxide powder having a mean particle size of 3.5 µ m was used instead of the cerium oxide powder having a mean particle size of 0.3 µ m in Example 1, to obtain 150 g of a polishing slurry. Into this polishing slurry was mixed 150 g of a 10% by weight aqueous solution of iron (III) nitrate 9 hydrate as an oxidizing agent to obtain an abrasive composition. The mixing ratio by weight of the the polishing slurry to the aqueous solution of iron (III) nitrate 9 hydrate herein was 1:1, the slurry concentration of the cerium oxide powder was 3% by weight, and the pH of the slurry was 1.1.

Using the resulting abrasive composition, a tungsten layer, titanium layer and silicon oxide layer were respectively polished in the same manner as in Example 1. The mean particle size of the abrasive particle and composition abstract of the abrasive composition are shown in Table 3, and the results of the measurements are shown in Table 4.

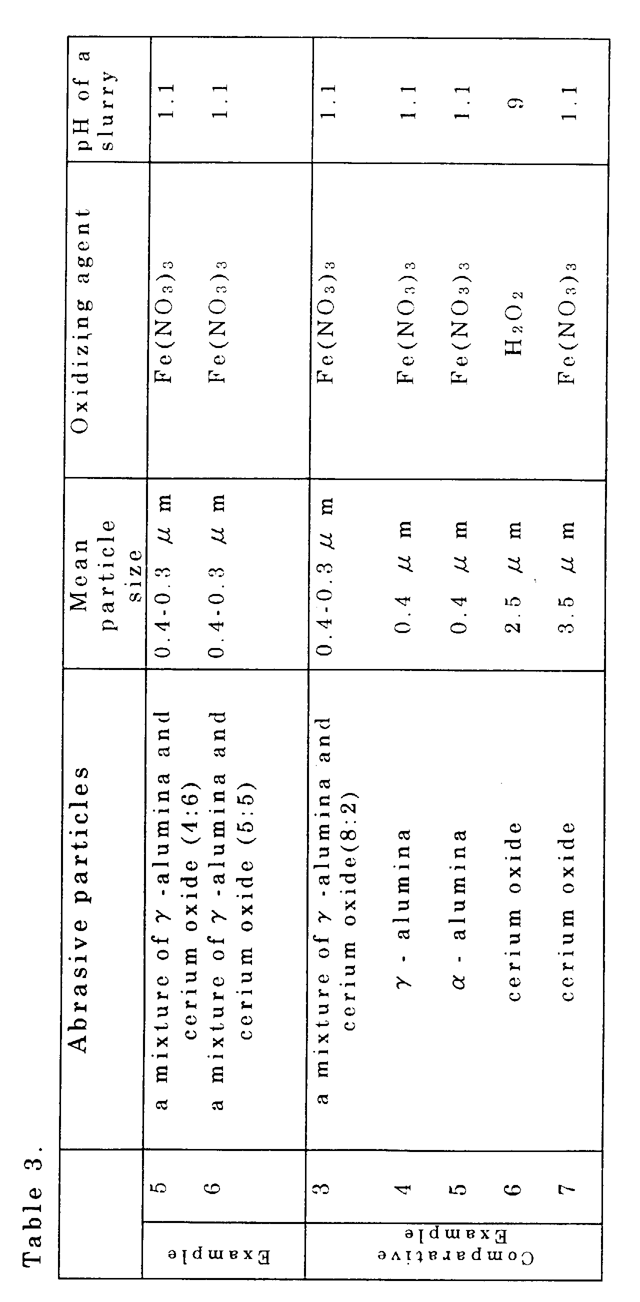

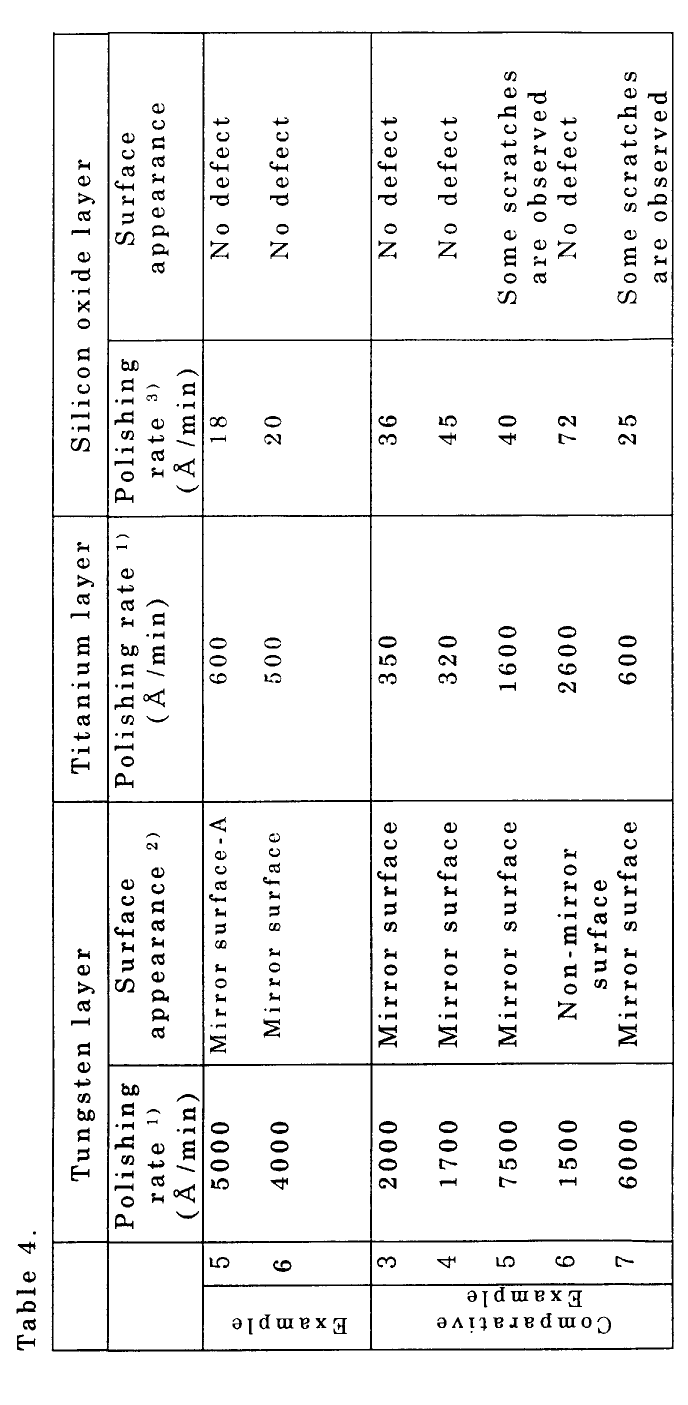

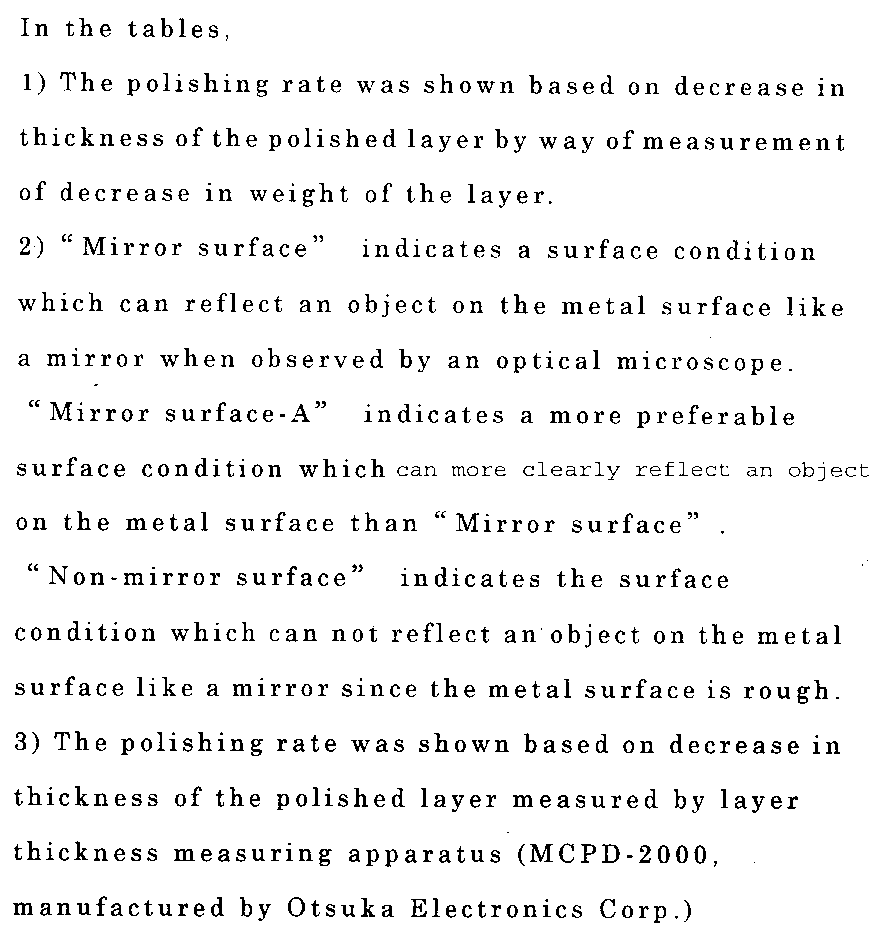

Table 4 shows that the abrasive composition of the present invention polishes a metal layer such as a tungsten layer or a titanium layer formed on a semiconductor substrate at high polishing rate without causing defects such as micro scratch and orange peel on the surface of the metal layer although the composition polishes an insulating layer only at low polishing rate. The composition also polishes the insulating layer without causing defects on the surface of the insulating layer. This indicates the composition has excellent polishing selectivity against the metal layer and the insulating layer without causing defects on the surfaces of both the metal layer and the insulating layer, and does not unnecessarily polish the insulating layer. Although some compositions in the Comparative examples polish the metal layer at high polishing rate, these cause defects on the surface of either the metal layer or the insulating layer and also polish the insulating layer at high polishing rate as well. This indicates such compositions have poor polishing selectivity against the metal layer and the insulating layer.

Fig. 1 is a polishing apparatus using the CMP method. Here, letter (a) indicates a wafer, letter (b) indicates a polishing pad, letter (c) indicates a wafer carrier, letter (d) indicates a polishing platen and letter (e) indicates a polishing composition, respectively.

Fig. 2 is a sectional view showing one example for forming an embedded metal wiring board using the conventional CMP method. Here, number 1 indicates a semiconductor substrate, number 2 indicates an insulating layer, number 3 indicates a metal contact layer, number 4 indicates an adhesion layer and number 5 indicates a metal layer for wiring, respectively.

## Claims

1. An abrasive composition comprising an oxidizing agent, abrasive particles which comprise cerium oxide, and optionally abrasive particles which comprise at least one oxide selected from (a) metal oxides other than cerium oxide and (b) silicon oxide, the abrasive particles having a mean particle size of 3 µm or less.

2. An abrasive composition according to claim 1, which comprises cerium oxide in an amount of about 50% or more by weight relative to the combined weight of cerium oxide and oxide(s) selected from (a) metal oxides other than cerium oxide and (b) silicon oxide.

3. An abrasive composition according to claim 1 or 2, wherein the oxide selected from (a) metal oxides other than cerium oxide and (b) silicon oxide is at least one oxide selected from aluminum oxide, silicon oxide, titanium oxide and zirconium oxide.

4. An abrasive composition according to claim 3, wherein the oxide is aluminum oxide.

5. An abrasive composition according to claim 4, wherein the aluminum oxide is transition alumina, amorphous alumina or a mixture thereof.

6. An abrasive composition according to any one of claims 1 to 5, wherein the oxidizing agent is at least one oxidizing agent selected from hydrogen peroxide, iron (III) nitrate, iodic acid and iodate.

7. A slurry comprising an abrasive composition according to any one of claims 1 to 6.

8. A slurry according to claim 7, which has a pH of about 7 or less.

9. A slurry according to claim 8, which has a pH of about 5 or less.

10. A slurry according to any one of claims 7 to 9, wherein the content of abrasive particles is from 1 to 30% by weight based on the slurry.

11. A method of polishing and planarizing a metal layer on a semiconductor substrate in which the metal layer is polished and planarized using an abrasive composition according to any one of claims 1 to 6 in the presence of water, or using a slurry according to any one of claims 7 to 10.

12. A method of providing a high polishing rate without causing defects on a metal layer on a semiconductor substrate in which the metal layer is polished using an abrasive composition according to any one of claims 1 to 6, or using a slurry according to any one of claims 7 to 10.

13. A method of increasing evenness of the surface of a metal layer on a semiconductor substrate in which the metal layer is polished using an abrasive composition according to any one of claims 1 to 6, or using a slurry according to any one of claims 7 to 10.

14. A method according to any one of claims 11 to 13, wherein the abrasive composition or slurry is used under a polishing condition in which the pH is about 7 or less.

15. A process for polishing the surface of a metal layer on a semiconductor substrate to prevent the occurrence of wire breaking in which the metal layer is polished using an abrasive composition according to any one of claims 1 to 6 in the presence of water, or using a slurry according to any one of claims 7 to 10.

16. Use of an abrasive composition according to any one of claims 1 to 6 or a slurry according to any one of claims 7 to 10 in a method according to any one of claims 11 to 14 or a process according to claim 15.
